# EUROPEAN PATENT APPLICATION

(11) **EP 1 164 702 A2**
(43) Date of publication of application: **19.12.2001**
(21) Application number: 01000207.9
(22) Date of filing: 12.06.2001
(51) Int. Cl.: H03M 3/02

(54) **Method of performing A/D conversion, and an A/D converter**

(30) Priority: 15.06.2000 FI 20001426
(71) Applicant: NOKIA MOBILE PHONES LTD., 02150 Espoo (FI)
(72) Inventor: Aunio, Antti, 90420 Oulu (FI)
(74) Representative: Karppinen, Olavi Arto

(57) **Abstract**

The invention relates to a method of performing AID conversion and to an A/D converter. The A/D conversion is performed by using at least two sigma-delta converters (50, 52) connected in cascade, the sigma-delta converters (50, 52) operating at a double sampling rate.

## Description

### FIELD OF THE INVENTION

The invention relates to A/D conversion using a sigma delta modulator.

### BACKGROUND OF THE INVENTION

Conversion of analogue signals into a digital form makes both the transmission and processing of signals easier and more efficient. A/D conversions are important in mobile phone technology, for example. One of such A/D converter arrangements is a cascaded second-order sigma-delta converter. The idea with a second-order sigma-delta converter is that the analogue signal to be converted is sampled by means of one second-order sigma-delta converter and the quantization error resulting from the conversion is sampled by means of another sigma-delta converter, the quantization error being subtracted from the samples of the signal. Such an arrangement is described in more detail in US patent 5061928, for example, herein incorporated by reference.

There are drawbacks in an A/D converter like this. A sigma-delta converter consumes a lot of current and power, because the settling time of the sampler and the amplifier is only half of the length of the sampling period, which consists of one or more clock cycles.

### BRIEF DESCRIPTION OF THE INVENTION

An object of the invention is to improve the AID conversion and the A/D converter implementing the method in order to decrease the current and power consumption. This is achieved by a method of performing A/D conversion, in which method the A/D conversion is carried out by using at least two sigma-delta converters connected in cascade, the sigma-delta converters operating at a double sampling rate.

An object of the invention is also an A/D converter comprising at least two sigma-delta converters connected in cascade, the sigma-delta converters being arranged to operate at a double sampling rate.

Preferred embodiments of the invention are disclosed in the dependent claims.

The invention is based on the idea that the A/D conversion is carried out by means of at least two cascaded sigma-delta converters, in which a double sampling rate is used. In the converter, the analogue input signal is converted by at least one sigma-delta converter, the quantization error of the converted signal is converted by means of at least one other sigma-delta converter, and the quantization error converted into a digital form is subtracted from the converted digital signal.

Several advantages are achieved by the method according to the invention. The current and power consumption of the sigma-delta converter will be decreased, which enables the use of high sampling rates.

### BRIEF DESCRIPTION OF THE DRAWINGS

The invention will be described in greater detail in connection with preferred embodiments, with reference to the attached drawings, in which

Figure 1 illustrates the sampling and forming of residue during the sampling period;

Figure 2 illustrates a block diagram of a receiver;

Figure 3A illustrates two cascaded sigma-delta converters;

Figure 3B illustrates a fourth-order sigma-delta converter; and

Figure 4 illustrates an embodiment of forming a double sampling rate.

### DETAILED DESCRIPTION OF THE INVENTION

An A/D converter according to the invention is applicable to a radio system receiver but not limited thereto. Radio systems include CDMA (Code Division Multiple Access), GSM (Global System for Mobile Communication), WCDMA (Wide Band CDMA) and TDMA (Time Division Multiple Access) systems.

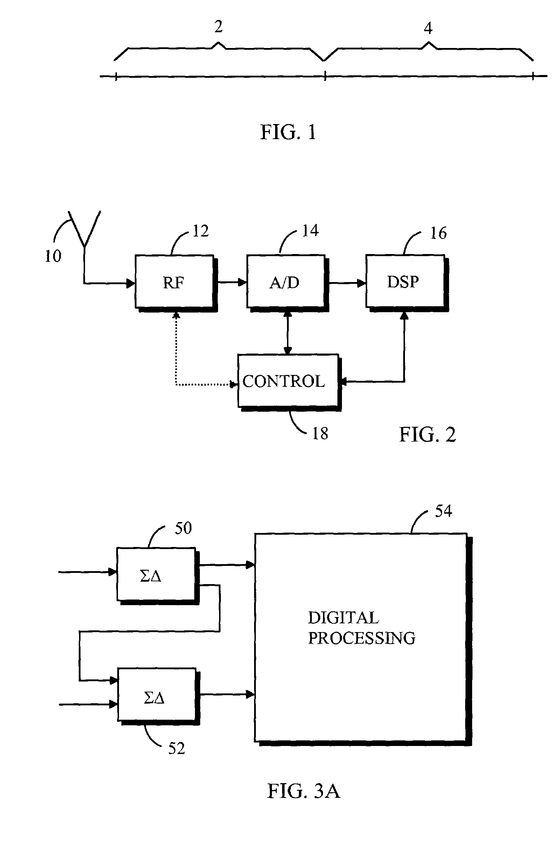

Figure 1 further clarifies conventional sampling. During the first half 2 of the sampling period a sample is taken, and during the second half 4 of the sampling period integration is carried out. Conventionally, the sample is taken into one or more capacitors present in the sampling and the integration is carried out by means of capacitors and amplifiers present in the integration. The sampling period, during which the sample is taken (or correspondingly, during which the sample is integrated), is conventionally one clock cycle controlling the operation of the sampling and integrating capacitors. In the arrangement of the invention, however, the sampling is performed in the half 2 of the sampling period and in the half 4 of the sampling period separately; in other words, two samplings are carried out during the sampling period. Correspondingly, the integration is effected during the half 2 and the half 4 of the sampling period separately. Hereby, a new sample is taken during the integration of the sample already taken, such a sampling rate being called a double sampling rate. The current and power consumption will, however, remain the same as at a single sampling rate.

Figure 2 illustrates a block diagram of a receiver. A radio-frequency signal received by means of an antenna 10 of the receiver proceeds to radio-frequency means 12, in which the received signal is converted into a baseband signal. This is usually carried out in such a way that the radio-frequency signal is multiplied by a radio-frequency signal of a local oscillator and the input signal formed is low-pass-filtered. The baseband signal is converted into a digital form in an A/D converter 14, after which the digital signal is processed in signal processing means 16. The operation of the receiver is controlled by a control block 18.

Figure 3A shows a block diagram of the cascade connection of two sigma-delta converters. The performance numbers of the sigma-delta converters may be the same or differ from each other. An analogue signal enters a first sigma-delta converter 50, the outputs of which are formed by a one-or multi-bit output signal 56 and a quantization error signal 58. The quantization error signal 58 is fed into a second sigma-delta converter 52, in which the quantization error is converted into a digital error signal 60. Both the output signal 56 and the error signal 60 are fed into a digital processing block 54, in which the quantization error is subtracted from the converted signal in a manner known *per se*. Although Figure 3A presents a cascade connection of only two sigma-delta converters, it will be obvious to a person skilled in the art that it is possible to connect several sigma-delta converters in cascade.

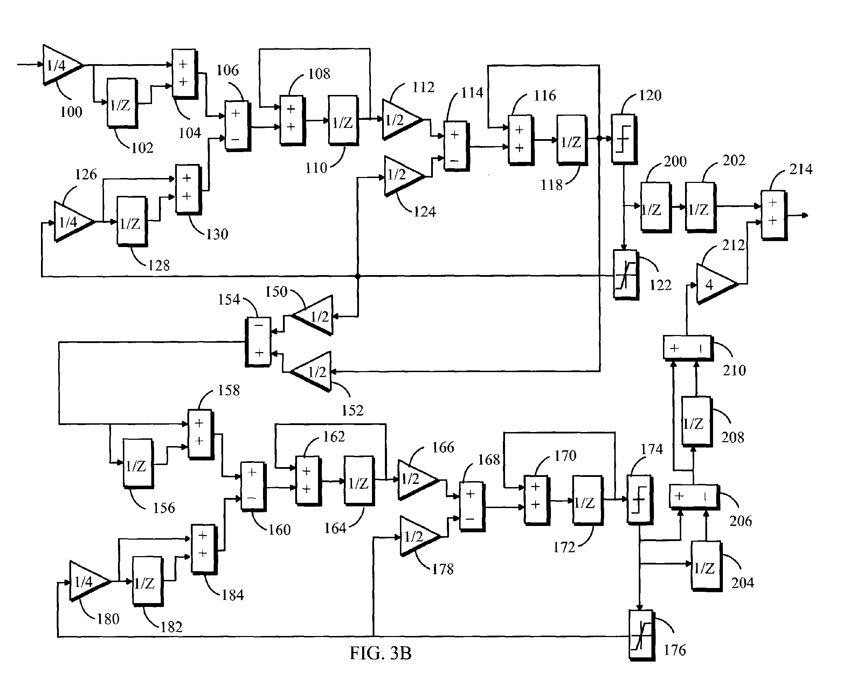

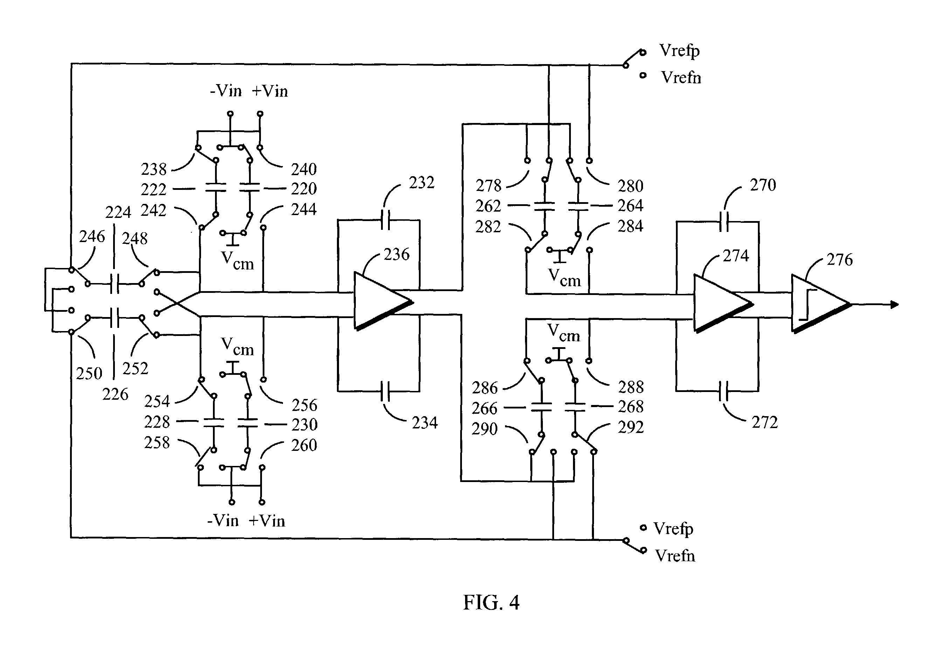

Figure 3B illustrates one embodiment for an A/D converter as a block diagram. The AID converter disclosed comprises a fourth-order sigma-delta converter, which has been formed by connecting two second-order sigma-delta converters in cascade. The analogue signal to be converted enters an amplifier 100, proceeding further to a delay element 102 and an adder 106. These blocks 100 to 104 form a first integrator, in which a sample is taken from the signal at a double sampling rate into capacitive units, and the sample charged in the capacitive units is amplified (sampling at a double sampling rate is described in more detail in connection with Figure 4). The integrated sample signal proceeds further to the next adder 106, in which a first feedback signal is subtracted from the sample signal. The difference signal is integrated in an integrator illustrated by means of an adder 108, a delay element 110 and an amplifier 112. In the integrator, a sample is taken from the signal at a double sampling rate. Subsequently, a second feedback signal is subtracted from the sample signal in an adder 114. The difference signal is integrated by an integrator illustrated by means of an adder 116 and a delay element 118. The integrated signal receives its digital value as the sign is determined in a sign element 120, which is a comparator, for example. By means of the sign, the value of the bit is determined either as -1 or 1, which correspond to the bit values 1 and 0. After the sign element 120, the signal branches into two feedback loops connected to different locations and into two digital signal-processing parts.

In the feedback, the quantized value is scaled in a scaling element 122 to be suitable for the feedback. The first feedback signal is further integrated in an integrator illustrated by an amplifier 126, a delay element 128 and an adder 130. Also in this integration, a double sampling rate is used. The integrated signal is subtracted in the adder 106. The second feedback signal is connected to the adder 114 through a sampling amplifier 124. The sampling in the amplifier 124 is performed at a double sampling rate. These functions in the blocks 100 - 124 are included in a first second-order sigma-delta amplifier 216.

A second sigma-delta converter 218 connected in cascade to the first sigma-delta converter operates in the same way as the first sigma-delta converter 216. The output signal of the first sigma-delta converter 216 and the input signal of the sign element 120 function as the input of the second sigma-delta converter 218. The difference of these two, formed by amplifiers 150 and 152 and an adder 154, corresponds to the quantization error. The difference signal is integrated in an integrator illustrated by a delay element 156 and an adder 158. The first subtraction of the feedback signal is carried out in an adder 160. Samples are taken from the difference signal at a double sampling rate, and the difference signal is integrated in an integrator illustrated by an adder 162, a delay element 164 and an amplifier 166. The second feedback signal is subtracted from the sample signal in an adder 168 and the difference signal is integrated in an integrator illustrated by an adder 170 and a delay element 172. The digital value of the quantization error is formed in a sign element 174. After the sign element 174 the signal branches into two feedback loops connected to different locations and into two digital signal-processing parts.

In the feedback, the value of the bit is scaled in a scaling element 176. The first feedback signal is further integrated in an integrator illustrated by an amplifier 180, a delay element 182 and an adder 184. Also in this integration, a double sampling rate is used. The integrated signal is subtracted in the adder 160. The second feedback signal is connected to the adder 168 through a sampling amplifier 178. The sampling in the amplifier 178 is performed at a double sampling rate. These functions in blocks 150 - 178 are included in the second-order sigma-delta converter 218.

The digital output signal of the first sigma-delta converter 216 proceeds to two delay elements 200 and 202. The delays correspond to the processing phases of the second sigma-delta converter 218 and keep the signals of the first and second sigma-delta converters synchronized. The digital output signal of the second sigma-delta converter 218 proceeds to a differentiator unit comprising two differentiators. The first differentiator comprises a delay element 204 as well as an adder 206, in which the delayed signal is subtracted from the output signal. The second differentiator comprises a delay element 208 as well as an adder 210, in which the delayed output signal of the adder 206 is subtracted from the output signal of the adder 206. The amplifier 212 scales the difference signal, which is added in the adder 214 to the delayed output signal of the first sigma-delta converter 216. In this way, a digital signal is converted into an analogue signal by using two cascaded second-order sigma-delta converters at a double sampling rate.

Figure 4 shows one embodiment of a second-order sigma-delta converter, corresponding essentially to the second-order sigma-delta converter disclosed in EP patent 901233. In the converter, a double sampling rate is used. A double sampling rate is achieved by a pair of capacitors. The arrangement in Figure 4 represents a bilinear converter, in which the amplifier functions as a differential amplifier and the disturbance that is caused by the mismatch resulting from possible different values of the sampling capacitors is connected to the common mode ground so as not to disturb the operation. The integration is carried out by exploiting common mode ground. As the operation of the converter is known *per se,* it will not be explained in detail here. The input of the converter is formed by a positive and a negative input voltage. When taking a sample during one sampling period consisting of one or more clock cycles, capacitors 220, 228 are connected to the positive input voltage and common mode ground by means of switches 238, 242, 254 and 258. Correspondingly, capacitors 222, 230 are connected to the negative input voltage by means of switches 240 and 256, being, however, connected to different input poles of an amplifier 236 by means of switches 244 and 260. As the sampling and integration can be performed during the whole sampling period, the sampling is called 'sampling at a double sampling rate'. Also feedback capacitors 246 and 226 are connected to the input poles. During the following sampling period, the capacitor connections are changed by means of switches. During each sampling phase, the amplifier 236 performs the integration of the sample that is charged in the capacitors connected to the input poles by means of capacitors 232 and 234. This corresponds to the blocks 108, 110 and 112 (or 162, 164 and 166) in Figure 2. The second integration phase corresponding to the integrators 116 and 118 (or 170 and 172) in Figure 2 comprises capacitors 262 to 272, switches 278 to 292 and an amplifier 274. Here, too, the double sampling rate is achieved by pairs of capacitors, which are alternately connected to function as sampling capacitors. The values of the capacitors 220 to 230 are four times higher than those of the capacitors 232 and 234. The values of the capacitors 270 and 272 are twice as high as those of the capacitors 262 to 268. A positive or a negative input voltage is selected by means of switches 294 and 296.

The arrangement according to the invention is applicable to one- or multi-bit conversions. In multi-bit conversion, the quantization is carried out on several levels (e.g. block 120, 174). Hereby, the output of one converter is formed by several bits at each conversion period.

Furthermore, the A/D converter may comprise sigma-delta converters of various orders in cascade instead of two second-order sigma-delta converters. For instance, the cascade may be formed by one second-order sigma-delta converter and one or two first-order sigma-delta converters. It is also possible to use a sigma-delta converter of a higher order. One or more sigma-delta converters may, in a cascade connection, perform multi-bit conversion instead of one-bit conversion.

While the invention has been described with reference to the example according to the appended drawings, it is obvious that the invention is not limited thereto but may be modified in many ways within the inventive idea defined in the appended claims.

## Claims

1. A method of performing A/D conversion, **characterized in that**
the A/D conversion is performed using at least two sigma-delta converters (50, 52) connected in cascade, the sigma-delta converters (50, 52) operating at a double sampling rate.

2. A method according to claim 1, **characterized in that** in order to use a double sampling rate, at least two capacitors are used in the sampling, the capacitors being changed at each sampling period.

3. A method according to claim 1, **characterized in that** the A/D converter converts a signal and the quantization error formed in the conversion of the signal at a double sampling rate and subtracts the quantization error from the converted signal.

4. A method according to claim 1, **characterized in that** the sigma-delta converter comprises at least one integrator, which is floating.

5. A method according to claim 1, **characterized in that** the sigma-delta converter comprises at least one integrator, which is differential.

6. A method according to claim 1, **characterized in that** the A/D conversion is performed as multi-bit conversion.

7. A method according to claim 1, **characterized in that** the sigma-delta converters (50, 52) are sigma-delta converters of the first or higher order.

8. A method according to claim 1, **characterized in that** the A/D converter comprises two sigma-delta converters (50, 52), of which at least one is a second-order sigma-delta converter.

9. An A/D converter, **characterized in that**
the A/D converter comprises at least two sigma-delta converters connected in cascade (50, 52), the sigma-delta converters (50, 52) being arranged to operate at a double sampling rate.

10. An A/D converter according to claim 9, **characterized in that** in order to use a double sampling rate, the A/D converter comprises at least two capacitors (222 to 230 and 262 to 268) in the sampling, which capacitors are changed at each sampling period.

11. An A/D converter according to claim 9, **characterized in that** the A/D converter is arranged to convert a signal and the quantization error formed in the conversion of the signal at a double sampling rate and to subtract the quantization error from the converted signal.

12. An A/D converter according to claim 9, **characterized in that** the sigma-delta converter (50, 52) comprises at least one integrator, which is floating.

13. An A/D converter according to claim 9, **characterized in that** the sigma-delta converter (50, 52) comprises at least one integrator, which is differential.

14. An A/D converter according to claim 9, **characterized in that** the AID conversion is performed as multi-bit conversion.

15. An A/D converter according to claim 9, **characterized in that** the sigma-delta converters (50, 52) are sigma-delta converters of the first or higher order.

16. An A/D converter according to claim 9, **characterized in that** the A/D converter comprises two sigma-delta converters (50, 52), of which at least one is a second-order sigma-delta converter.
